# EUROPEAN PATENT APPLICATION

(11) **EP 4 342 780 A1**
(43) Date of publication of application: **27.03.2024**
(21) Application number: 22804395.6
(22) Date of filing: 28.03.2022
(51) Int. Cl.: B63B 1/08, B63B 35/08

(54) **ICEBREAKER SHIP AND METHOD FOR DESIGNING ICEBREAKER SHIP**

(30) Priority: 19.05.2021 JP 2021084454
(71) Applicant: Japan Marine United Corporation, Yokohama-City, Kanagawa 220-0012 (JP)
(72) Inventor: MIZUNO Shigeya, Yokohama-City Kanagawa 220-0012 (JP); YAMAUCHI Yutaka, Yokohama-City Kanagawa 220-0012 (JP); ANZAI Keisuke, Yokohama-City Kanagawa 220-0012 (JP); MASUDA Satoshi, Yokohama-City Kanagawa 220-0012 (JP)
(74) Representative: Kraus & Lederer PartGmbB
(86) International application number: PCT/JP2022/014840
(87) International publication number: WO 2022/244477

(57) **Abstract**

To provide an icebreaker and a method of designing an icebreaker wherein it is possible to suppress a decrease in propulsion efficiency by a hull outer plate shape near a stern portion without using an additional object. An icebreaker 1 according to a first embodiment is capable of advancing while breaking ice plates, and includes a chine 4 formed to constitute a boundary between a vessel side portion 2 and a vessel bottom portion 3. A start point P1 of the chine 4 can be arbitrarily set within a range of 0% to 50% inclusive above a propeller diameter D (a range including a first region A1 and a second region A2) with reference to a propeller center height L0.

## Description

### Technical Field

The present invention relates to an icebreaker and a method of designing an icebreaker, and particularly to an icebreaker having a feature in a hull outer plate shape near a stern portion and a method of designing the icebreaker.

### Background Art

An icebreaker is a vessel that moves forward while breaking ice plates by a bow portion. Crushed ice pieces sink under a water surface as the hull advances, and flow rearward along the side of the hull. With a typical stern shape having a continuous curved section, ice pieces lined up along the side of the hull tend to move inward toward a stern portion and flow into a propulsor. When the ice pieces flow to a propulsor, the ice pieces collide with the propeller and are crushed, causing an increase in torque and a decrease in thrust, and thus the propulsion efficiency decreases.

In order to suppress the interference between the ice pieces and the propeller, in the invention described in Patent Literature 1, a chine is formed at an intersection portion between the vessel bottom and the side of the hull, and a bilge keel is disposed on an outer side of the chine at a rear portion from a hull center portion toward the stern.

### Citation List

### Patent Literature

Patent Literature 1: JP 2837930 B2

### Summary of Invention

### Technical Problem

As in the bilge keel described in Patent Literature 1, an additional object for changing the flow of ice pieces is one of effective means, but a propulsion resistance increases due to the interference between the additional object and ice pieces. Further, there is a problem that the additional object is likely to be damaged due to the contact with ice pieces. Further, the additional object increases the propulsion resistance in smooth water (water area without ice), causing a decrease in propulsion efficiency.

The present invention has been made in view of the above problems, and an object of the present invention is to provide an icebreaker and a method of designing an icebreaker wherein it is possible to suppress the decrease in propulsion efficiency by a hull outer plate shape near the stern portion without using an additional object.

### Solution to Problem

According to the present invention, there is provided an icebreaker capable of advancing while breaking an ice plate, the icebreaker including: a chine that is formed to constitute a boundary between a vessel side portion and a vessel bottom portion, wherein the chine has a start point in a range of 0% to 50% inclusive above a propeller diameter with reference to a propeller center height.

The chine may have a terminal point in a range of 25% above the propeller diameter to a water surface inclusive with reference to the propeller center height.

The chine may have a start point in a range of 0% to 25% inclusive above the propeller diameter, and have a terminal point in a range of 50% above the propeller diameter to a water surface inclusive.

The chine may have a start point in a range of 25% to 50% inclusive above the propeller diameter, and have a terminal point in a range of 50% above the propeller diameter to a water surface inclusive.

The chine may have a start point in a range of 0% to 25% inclusive above the propeller diameter, and have a terminal point in a range of 25% to 50% inclusive above the propeller diameter.

The chine may have a start point in a range of 25% to 50% inclusive above the propeller diameter, and have a terminal point in a range of 25% to 50% inclusive above the propeller diameter.

The chine may be divided into a plurality of parts in a longitudinal direction.

According to the present invention, there is provided a method of designing an icebreaker capable of advancing while breaking an ice plate, wherein a chine is formed to constitute a boundary between a vessel side portion and a vessel bottom portion with reference to a position of a propeller.

A start point of the chine may be set in a range of 0% to 50% inclusive above the propeller diameter with reference to a propeller center height.

A terminal point of the chine may be set in a range of 25% above the propeller diameter to a water surface inclusive with reference to a propeller center height.

### Advantageous Effects of Invention

According to the icebreaker of the present invention, the chine is formed in a predetermined range to constitute the boundary between the vessel side portion and the vessel bottom portion with reference to the position of the propeller constituting the propulsor, whereby the movement of ice pieces to the vessel bottom portion can be restricted, and the decrease in propulsion efficiency can be suppressed by the hull outer plate shape near the stern portion without using an additional object.

### Brief Description of Drawings

Fig. 1 is a partial side view showing an icebreaker according to a first embodiment of the present invention.
Fig. 2 is a sectional line diagram showing the icebreaker according to the first embodiment of the present invention.
Fig. 3 is a sectional line diagram showing an icebreaker of a comparative example.
Fig. 4 is a chart showing an ice piece interference influence degree.
Fig. 5 is a sectional line diagram showing an icebreaker according to a second embodiment of the present invention.
Fig. 6 is a partial side view showing an icebreaker according to a third embodiment of the present invention.
Fig. 7 is a partial side view showing an icebreaker according to a fourth embodiment of the present invention.
Fig. 8 is a partial side view showing an icebreaker according to a fifth embodiment of the present invention.
Fig. 9 is a partial side view showing an icebreaker according to a sixth embodiment of the present invention.

### Description of Embodiments

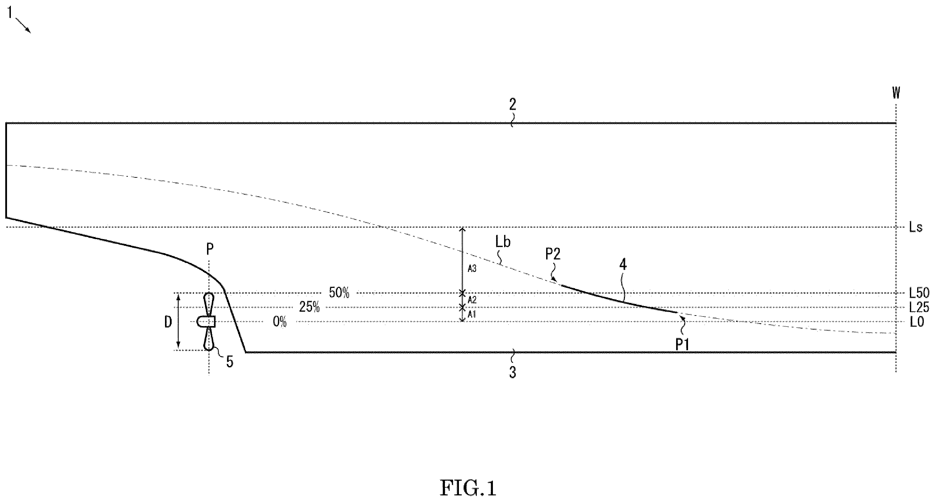

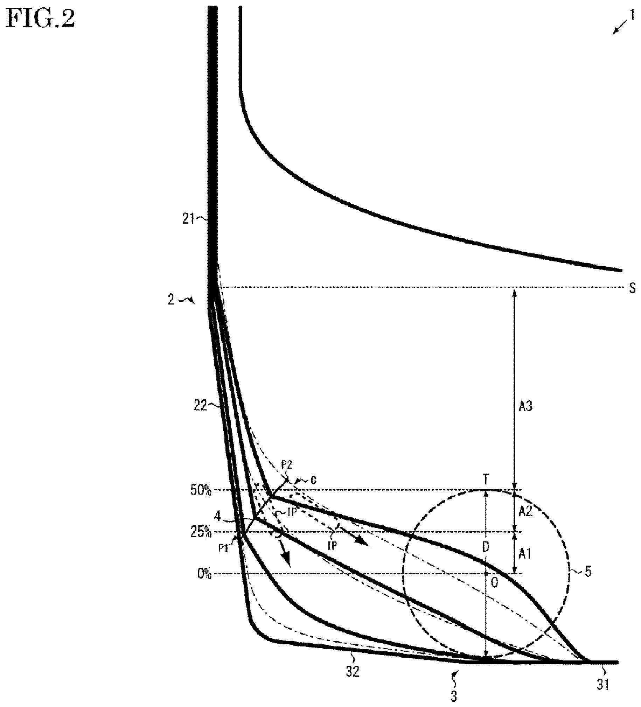

Hereinafter, embodiments of the present invention will be described with reference to Figs. 1 to 9. Here, Fig. 1 is a partial side view showing an icebreaker according to a first embodiment of the present invention. Fig. 2 is a sectional line diagram showing the icebreaker according to the first embodiment of the present invention.

An icebreaker 1 according to the first embodiment of the present invention is, for example, an icebreaker capable of advancing while breaking ice plates, as shown in Figs. 1 and 2, and includes a chine 4 formed to constitute a boundary between a vessel side portion 2 and a vessel bottom portion 3. The icebreaker 1 according to the present embodiment does not include an additional object such as a bilge keel arranged along the vessel bottom portion 3. Note that a boundary Lb indicated by a dashed-dotted line in Fig. 1 is a conceptual line that is drawn to easily image the boundary between the vessel side portion 2 and the vessel bottom portion 3 for convenience of description.

Fig. 1 shows only a stern portion, which is located rearward of a maximum width rear end portion W of a hull of the icebreaker 1. Fig. 2 shows only a port side of the icebreaker 1. The sectional line diagram shown in Fig. 2 is a two dimensional diagram obtained by cutting the hull in the vertical direction at regular intervals from the maximum width rear end portion W toward a propeller position P and displaying sectional shapes in an overlapping manner.

The vessel side portion 2 is constituted of a vessel side outer plate that constitutes a side surface of the hull. For example, as shown in Fig. 2, the vessel side portion 2 includes a vertical surface portion 21 constituted of a substantially vertical surface and an inclined surface portion 22 constituted in a manner that the width thereof decreases toward the vessel bottom portion 3. The inclined surface portion 22 may be constituted of a flat surface or may include a curved surface.

The vessel bottom portion 3 is constituted of a vessel bottom outer plate that constitutes a bottom surface of the hull. For example, as shown in Fig. 2, the vessel bottom portion 3 includes a horizontal plane portion 31 constituted of a substantially horizontal plane and a gradient surface portion 32 constituted in a manner that the depth thereof becomes shallower toward the vessel side portion 2. The gradient surface portion 32 may be constituted of a flat surface or may include a curved surface.

As shown by a dashed-dotted line in Fig. 2, a conventional icebreaker includes a bilge portion C which constitutes a curved portion connecting a vessel side portion and a vessel bottom portion. The chine 4 according to the present embodiment is constituted by forming a ridge or a ridgeline having a pointed tip on the conventional bilge portion C. The chine 4 is constituted of, for example, an extension of the inclined surface portion 22 of the vessel side portion 2 and an extension of the gradient surface portion 32 of the vessel bottom portion 3.

Generally, the volume of the hull is fixed, and thus, in a case where a convex portion is formed on the hull by forming the chine 4, a concave portion needs to be formed in another portion by the amount of the convex portion. According to the present embodiment, a concave portion is formed in the gradient surface portion 32 of the vessel bottom portion 3 on the stern side.

In a case where the chine 4 is formed long in the longitudinal direction of the hull, the propulsion resistance in smooth water increases, and therefore, it is preferable that the area in which the chine 4 is formed is as small as possible. Therefore, in the method of designing the icebreaker 1 according to the present embodiment, the chine 4 is formed with reference to a position of a propeller 5.

The icebreaker 1 is provided with the propeller 5 constituting a propulsor at the stern portion. The icebreaker 1 is, for example, a multi-shaft vessel having two shafts or three shafts, and the propeller 5 is, for example, a wing propeller arranged on the port side or starboard side. In Fig. 1, components (propeller shaft, rudder, and the like) related to the propulsor other than the propeller 5 are not shown.

As shown in Fig. 1, a propeller diameter of the propeller 5 is defined as D, and a straight line drawn horizontally from a rotation center O of the propeller 5 is defined as a propeller center height L0. A straight line drawn at a position 25% above the propeller diameter D with reference to the propeller center height L0 is defined as L25. A straight line drawn at a position 50% above the propeller diameter D with reference to the propeller center height L0 (that is, a vertex T of the propeller 5) is defined as L50.

A straight line drawn at a position of a water surface S with respect to the icebreaker 1 is defined as Ls. The position of the water surface S varies in a range from light draft line to full draft line depending on the weight of the cargo, fuel, ballast water, and the like of the icebreaker 1. The range of the straight lines L50 to Ls exceeds 50% of the propeller diameter D, and thus means a position above the propeller 5.

As shown in Fig. 2, a region in the height direction formed by a horizontal plane including the propeller center height L0 and a horizontal plane including the straight line L25 is defined as a first region A1, a region in the height direction formed by the horizontal plane including the straight line L25 and a horizontal plane including the straight line L50 is defined as a second region A2, and a region in the height direction formed by the horizontal plane including the straight line L50 and the water surface S is defined as a third region A3.

If an end point of the chine 4 on the bow side is defined as a start point P1 and an end point of the chine 4 on the stern side is defined as a terminal point P2, as shown in Fig. 2, the start point P1 of the chine 4 is set in the first region A1 and the terminal point P2 of the chine 4 is set in the third region A3. Therefore, the chine 4 is formed over the entire second region A2. The chine 4 is set such that the terminal point P2 is above the start point P1 in consideration of the direction of the water flow on the hull surface.

In a conventional icebreaker without the chine 4, ice pieces IP move along the vessel bottom portion, as indicated by the arrow, and flow into the propeller 5.

In contrast, in the icebreaker 1 according to the present embodiment, the chine 4 having a convex shape is provided at a position where the ice pieces IP go around to the vessel bottom portion 3, and thus the ice pieces IP need to rotate from the vessel side portion 2 toward the vessel bottom portion 3 while receiving resistance of water in order to go around to the vessel bottom portion 3, and accordingly, a large kinetic energy is required.

Therefore, the movement of the ice pieces IP flowing into the vessel bottom portion 3 can be restricted, and the decrease in propulsion efficiency can be suppressed by the hull outer plate shape near the stern portion without using an additional object such as a bilge keel. Further, no additional object is used in the icebreaker 1 according to the present embodiment, and thus, it is possible to prevent the occurrence of problems such as an increase in propulsion resistance due to interference between an additional object and the ice pieces IP, damage to the additional object due to contact with the ice pieces IP, and the like.

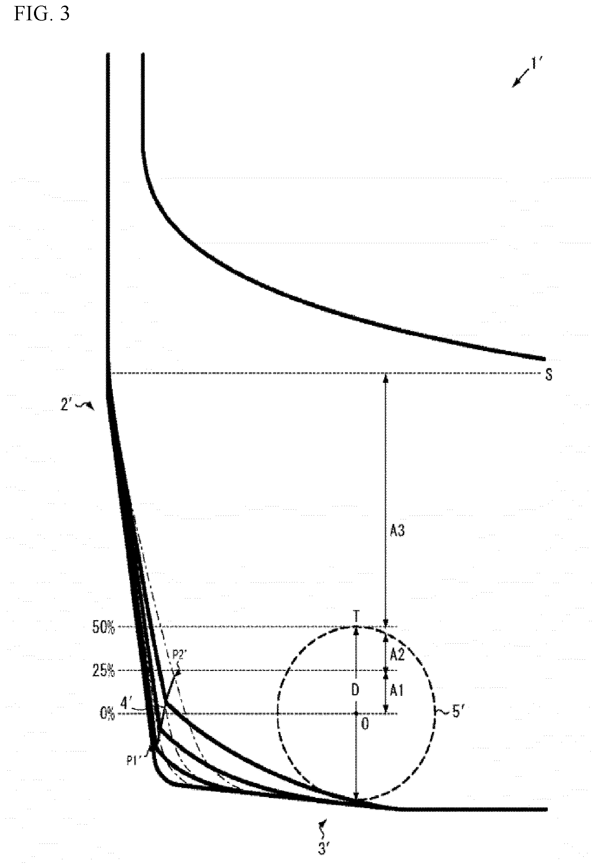

Here, Fig. 3 is a sectional line diagram showing an icebreaker of a comparative example. In the icebreaker 1' of the comparative example shown in Fig. 3, the start point P1' of the chine 4' is set below the propeller center height L0, and the terminal point P2' of the chine 4' is set in the first region A1. That is, in the comparative example, the chine 4' is formed at a position deeper than the chine 4 according to the first embodiment shown in Fig. 2. The icebreaker 1' includes a vessel side portion 2', a vessel bottom portion 3', a propeller 5', and the like, as in the icebreaker 1 according to the first embodiment.

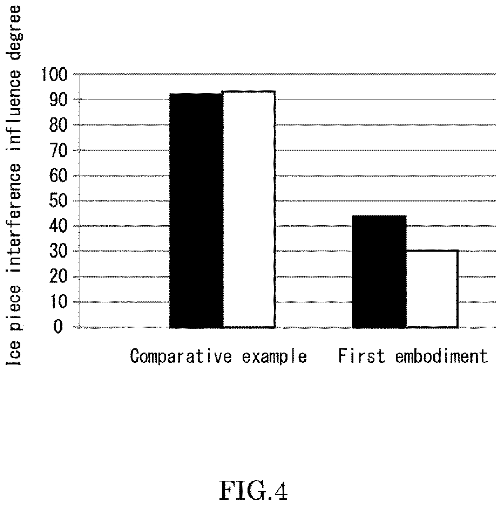

Fig. 4 shows the results of measurement of the ice piece interference influence degree using a hull model of the comparative example and a hull model of the first embodiment. In the figure, the black bar graph indicates the test results of the conventional hull shapes without the chines 4, 4', and the white bar graph indicates the hull shapes having the chines 4, 4'.

The ice piece interference influence degree is obtained by measuring a propulsion performance of each hull model and converting the ice piece interference influence degree into a numerical value in a range of 0 to 100 inclusive based on an improvement rate of the propulsion performance. In a case where the propulsion performance is improved, the ice piece interference influence degree is a low numerical value, and in a case where the propulsion performance is not improved, the ice piece interference influence degree is a high numerical value.

As shown in Fig. 4, in the comparative example shown in Fig. 3, the ice piece interference influence degree does not change greatly depending on the presence or absence of the chine 4', and the ice piece interference influence degree is substantially the same in consideration of the analysis accuracy.

In contrast, in the first embodiment shown in Fig. 2, by forming the chine 4, the propulsion performance can be improved, and the ice piece interference influence degree can be reduced by 10% or more.

It is considered that although the range in which the chine 4 is formed varies depending on the hull shape of the icebreaker 1, in view of the above-described test results, it is preferable that the chine 4 has the start point P1 in a range of 0% to 50% inclusive above the propeller diameter D with reference to the propeller center height L0. It is also considered preferable that the chine 4 has the terminal point P2 in a range from 25% above the propeller diameter D to the water surface S inclusive with reference to the propeller center height L0.

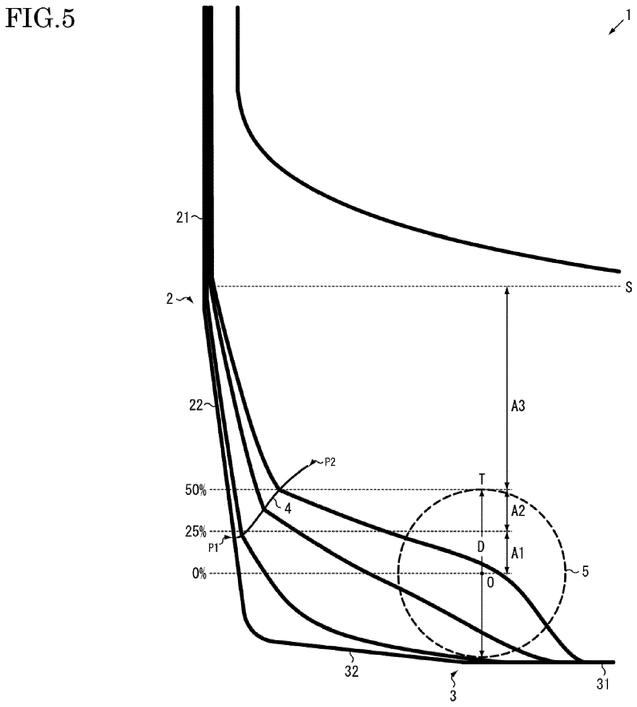

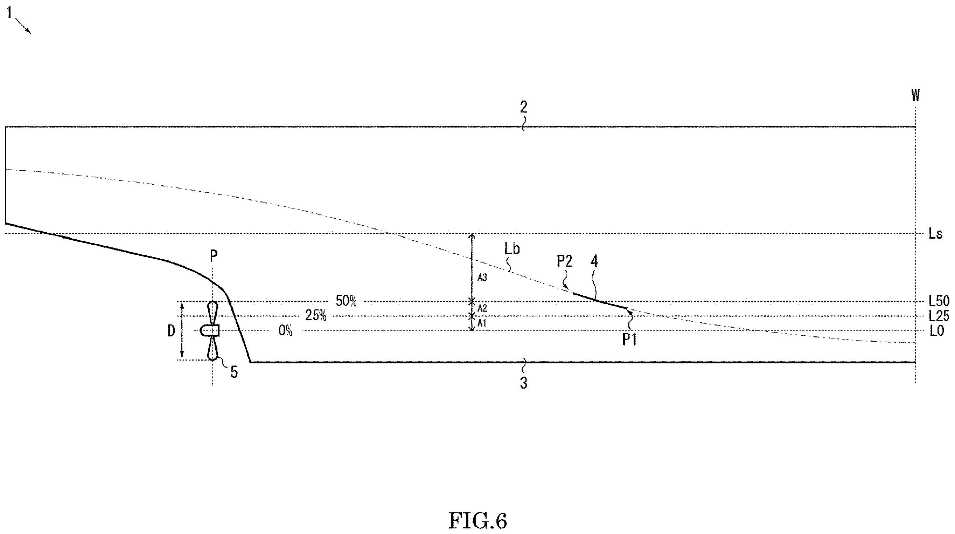

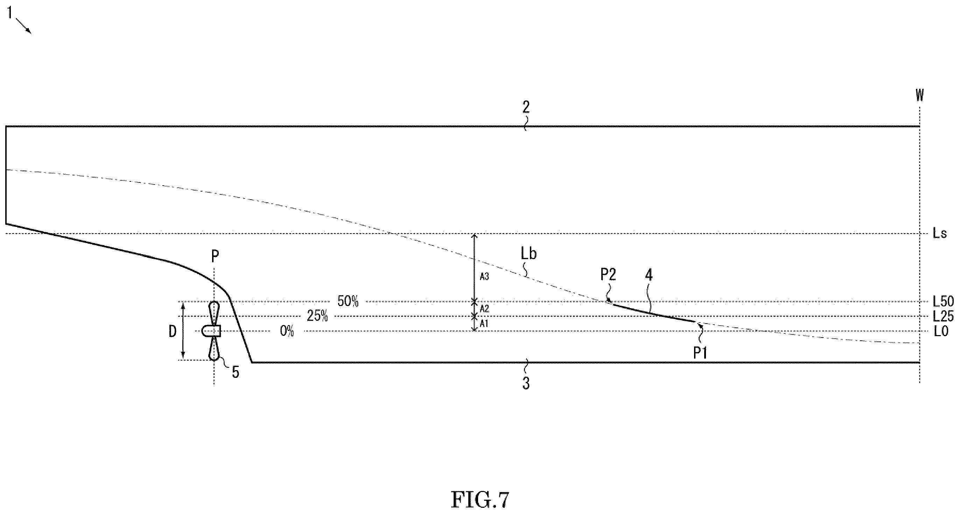

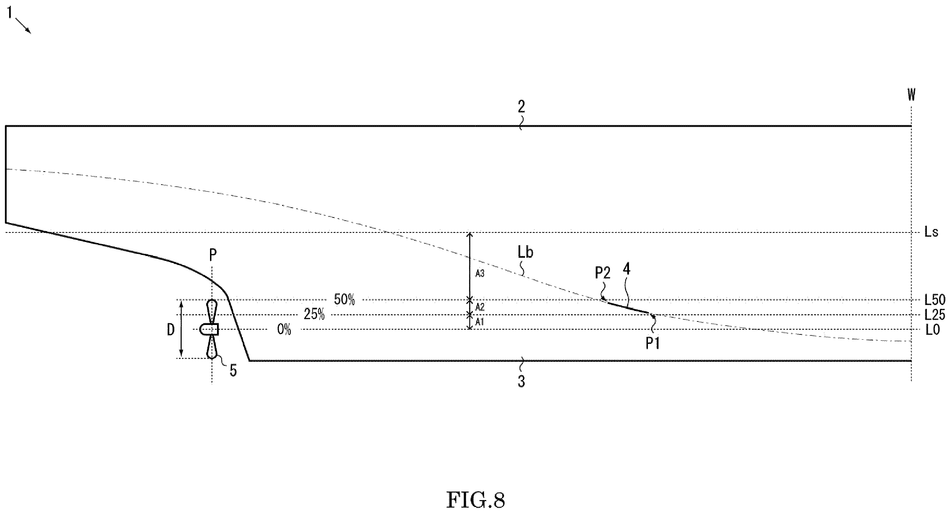

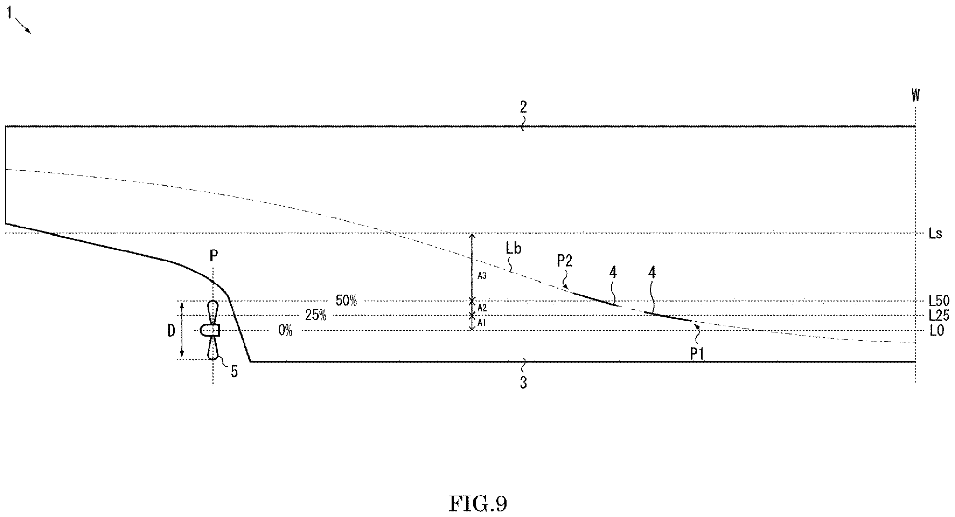

Next, the icebreaker 1 according to another embodiment of the present invention will be described with reference to Figs. 5 to 8. Here, Fig. 5 is a sectional line diagram showing an icebreaker according to a second embodiment of the present invention. Fig. 6 is a partial side view showing an icebreaker according to a third embodiment of the present invention. Fig. 7 is a partial side view showing an icebreaker according to a fourth embodiment of the present invention. Fig. 8 is a partial side view showing an icebreaker according to a fifth embodiment of the present invention. Fig. 9 is a partial side view showing an icebreaker according to a sixth embodiment of the present invention. The same components as those of the icebreaker 1 according to the first embodiment are denoted by the same reference signs, and the description thereof will not be repeated.

In the second embodiment shown in Fig. 5, the start point P1 of the chine 4 is set in the first region A1, and the terminal point P2 of the chine 4 is set in the third region A3, as in the first embodiment shown in Fig. 2. The chine 4 according to the second embodiment is formed to be longer in the longitudinal direction of the hull than that of the first embodiment. Thus, the start point P1 of the chine 4 can be set at an arbitrary position in the first region A1, and the terminal point P2 of the chine 4 can be set at an arbitrary position in the third region A3.

In the third embodiment shown in Fig. 6, the start point P1 of the chine 4 is set in the second region A2, and the terminal point P2 of the chine 4 is set in the third region A3. Thus, in a case where the position of the start point P1 of the chine 4 is set in the second region A2 immediately above the first region A1, the movement of the ice pieces IP flowing into the vessel bottom portion 3 can also be restricted, and the decrease in propulsion efficiency can also be suppressed by the hull outer plate shape near the stern portion, as in the first embodiment.

In the fourth embodiment shown in Fig. 7, the start point P1 of the chine 4 is set in the first region A1, and the terminal point P2 of the chine 4 is set in the second region A2. Thus, in a case where the position of the terminal point P2 of the chine 4 is set in the second region A2 immediately below the third region A3, the movement of the ice pieces IP flowing into the vessel bottom portion 3 can also be restricted, and the decrease in propulsion efficiency can also be suppressed by the hull outer plate shape near the stern portion, as in the first embodiment.

In the fifth embodiment shown in Fig. 8, the start point P1 of the chine 4 is set in the second region A2, and the terminal point P2 of the chine 4 is also set in the same second region A2. Here, the terminal point P2 is set at a position above the start point P1.

Thus, in a case where the start point P1 and the terminal point P2 of the chine 4 are set in the same second region A2, the movement of the ice pieces IP flowing into the vessel bottom portion 3 can also be restricted, and the decrease in propulsion efficiency can also be suppressed by the hull outer plate shape near the stern portion, as in the first embodiment.

According to the icebreaker 1 of the first to fifth embodiments described above, the start point P1 of the chine 4 can be set arbitrarily within a range of 0% to 50% inclusive above the propeller diameter D (a range including the first region A1 and the second region A2) with reference to the propeller center height L0.

The terminal point P2 of the chine 4 can be arbitrarily set within a range from 25% above the propeller diameter D to the water surface S inclusive (the second region A2 and the third region A3) with reference to the propeller center height L0. Here, the terminal point P2 is set at a position above the start point P1.

According to the icebreaker 1 of the first to fifth embodiments, it is considered preferable that the chine 4 includes a part of the chine 4 in at least the second region A2.

In the sixth embodiment shown in Fig. 9, the chine 4 is divided into two parts in the longitudinal direction and arranged. In the case where the chine 4 is divided in this way, the start point P1 is also the end point of the entire chine 4 on the bow side, and the terminal point P2 is also the end point of the entire chine 4 on the stern side. The chine 4 may be divided into 3 or more parts in the longitudinal direction.

Note that, in the first to sixth embodiments described above, the description is made assuming that the propeller 5 is a wing propeller of a 2-shaft or 3-shaft vessel, but the propeller 5 used as a reference when setting the chine 4 may be a propeller of a single-shaft vessel, a wing propeller of a multi-shaft vessel having four or more shafts, or a center propeller of a multi-shaft vessel.

It goes without saying that the present invention is not limited to the embodiments described above, and that various modifications can be made without departing from the gist of the present invention.

## Claims

1. An icebreaker capable of advancing while breaking an ice plate, the icebreaker comprising:
a chine that is formed to constitute a boundary between a vessel side portion and a vessel bottom portion, wherein
the chine has a start point in a range of 0% to 50% inclusive above a propeller diameter with reference to a propeller center height.

2. The icebreaker according to claim 1, wherein
the chine has a terminal point in a range of 25% above the propeller diameter to a water surface inclusive with reference to the propeller center height.

3. The icebreaker according to claim 2, wherein
the chine has a start point in a range of 0% to 25% inclusive above the propeller diameter, and has a terminal point in a range of 50% above the propeller diameter to a water surface inclusive.

4. The icebreaker according to claim 2, wherein
the chine has a start point in a range of 25% to 50% inclusive above the propeller diameter, and has a terminal point in a range of 50% above the propeller diameter to a water surface inclusive.

5. The icebreaker according to claim 2, wherein
the chine has a start point in a range of 0% to 25% inclusive above the propeller diameter, and has a terminal point in a range of 25% to 50% inclusive above the propeller diameter.

6. The icebreaker according to claim 2, wherein
the chine has a start point in a range of 25% to 50% inclusive above the propeller diameter, and has a terminal point in a range of 25% to 50% inclusive above the propeller diameter.

7. The icebreaker according to claim 1, wherein
the chine is divided into a plurality of parts in a longitudinal direction.

8. A method of designing an icebreaker capable of advancing while breaking an ice plate, wherein
a chine is formed to constitute a boundary between a vessel side portion and a vessel bottom portion with reference to a position of a propeller.

9. The method according to claim 8, wherein
a start point of the chine is set in a range of 0% to 50% inclusive above the propeller diameter with reference to a propeller center height.

10. The method according to claim 8, wherein
a terminal point of the chine is set in a range of 25% above the propeller diameter to a water surface inclusive with reference to a propeller center height.
